# EUROPEAN PATENT SPECIFICATION

(11) **EP 2 957 652 B1**
(45) Date of publication and mention of the grant of the patent: **01.11.2017**
(21) Application number: 14751176.0
(22) Date of filing: 18.02.2014
(51) Int. Cl.: C23C 8/38, C21D 8/12, C21D 9/46, H01F 1/16

(54) **APPARATUS AND METHOD FOR NITRIDING GRAIN-ORIENTED ELECTRICAL STEEL SHEET**
VORRICHTUNG UND VERFAHREN ZUR NITRIERUNG EINES KORNORIENTIERTEN ELEKTROSTAHLBLECHS
APPAREILLAGE DE NITRURATION POUR TÔLE D'ACIER ÉLECTROMAGNÉTIQUE ORIENTÉ ET PROCÉDÉ DE NITRURATION

(30) Priority: 18.02.2013 JP 2013029368
(43) Date of publication of application: 23.12.2015
(73) Proprietor: JFE Steel Corporation, Tokyo, 100-0011 (JP)
(72) Inventor: MATSUDA, Hiroshi, Tokyo 100-0011 (JP); TAKAHASHI, Hideyuki, Tokyo 100-0011 (JP); YAMAGUCHI, Hiroi, Tokyo 100-0011 (JP); HAYAKAWA, Yasuyuki, Tokyo 100-0011 (JP); TERASHIMA, Takashi, Tokyo 100-0011 (JP); WAKISAKA, Yuiko, Tokyo 100-0011 (JP)
(74) Representative: Hoffmann Eitle
(86) International application number: PCT/JP2014/000820
(87) International publication number: WO 2014/125841

(56) References cited:
- JP-A- H 046 221
- JP-A- H02 213 460
- JP-A- H02 213 460
- JP-A- H04 131 376
- JP-A- H04 136 154
- JP-A- H04 235 222
- JP-A- H08 158 038
- JP-A- H08 158 038
- JP-A- H09 118 964
- US-A1- 2005 112 377
- US-B1- 6 361 628

## Description

### TECHNICAL FIELD

The disclosure relates to an apparatus and a method that are suitable for nitriding a grain-oriented electrical steel sheet.

### BACKGROUND

A grain oriented electrical steel sheet is a soft magnetic material used as an iron core material of transformers and generators, and is required to have excellent magnetic properties, in particular low iron loss. This steel sheet has a texture in which the <001> direction, which is an easy magnetization axis of iron, is highly accorded with the rolling direction of the steel sheet. Such texture is formed through the so-called secondary recrystallization where crystal grains with (110)[001] orientation referred to as Goss orientation are preferentially grown massively, during secondary recrystallization annealing in the production process of the grain-oriented electrical steel sheet.

Conventionally, such grain-oriented electrical steel sheets have been manufactured by heating a slab containing 4.5 mass% or less of Si and inhibitor components such as MnS, MnSe and AlN to 1300 °C or higher, thereby dissolving the inhibitor components, then subjecting the slab to hot rolling to obtain a hot rolled steel sheet, and then subjecting the hot rolled steel sheet to hot band annealing as necessary, and subsequent cold rolling once, or twice or more with intermediate annealing performed therebetween until reaching final sheet thickness, then subjecting the steel sheet to primary recrystallization annealing in wet hydrogen atmosphere to perform primary recrystallization and decarburization, and then applying thereon an annealing separator mainly composed of magnesia (MgO) and performing final annealing at 1200 °C for around 5 hours for secondary recrystallization and purification of inhibitor components (e.g. see US1965559A (PTL 1), JPS4015644B (PTL 2) and JPS5113469B (PTL 3)).

However, high temperature heating of a slab not only causes an increase in apparatus costs to achieve heating, but also increases the amount of scale generated during hot rolling and decreases production yield, and further, it causes problems including complicated maintenance of facilities, and therefore, recent demands for reduction in production costs could not be met.

For this reason, various developments have been made for a technique of causing secondary recrystallization without containing inhibitor components in the slab. For example, a technique capable of stably causing secondary recrystallization without containing inhibitor components in the slab, by increasing S content in the steel matrix after primary recrystallization annealing and before completion of secondary recrystallization (sulfur increasing method) has been proposed (JP4321120B (PTL 4)).

Further, a technique that enables strengthening inhibitors after primary recrystallization annealing and before completion of secondary recrystallization and stably causing secondary recrystallization without containing inhibitor components in the slab, by performing gas nitriding before or after decarburization annealing (JP2771634B (PTL 5)), as well as a technique of disposing a reducing zone in front of a nitriding zone to provide a reducing effect to the oxide layer of the steel sheet surface (JPH03122227A (PTL 6)) have been proposed.

Further, in order to perform uniform nitriding over the whole strip during such gas nitriding process, a method of dividing and adjusting the nitriding gas supplied by a nozzle or a spray at the center part of the steel sheet and both ends of the steel sheet, has been proposed (JP3940205B (PTL 7)).

In addition, JP H08 158 038 A discloses a plasma treating device wherein a hearth roll for supporting a strip continuously supplied into a carburization furnace is grounded and used as a main cathode, and a low-temp. plasma electrode pair is formed with the auxiliary cathodes parallel to both faces of the strip and the anodes opposed to and parallel with both side edges of the strip in the width direction and vertical to the strip face. The furnace is reduced to a specified pressure by the pressure reducing band set on the inlet and outlet sides of the furnace, the carburizing gas and a voltage to be impressed on the anodes are variably controlled, and the strip is carburized with the continuous low-temperature plasma. A strip temperature adjusting band and a cooling band are arranged on the outlet side of the carburization furnace to control the diffusion rate of the solid-soln.

JP H04 136154 A discloses a plasma treating device wherein a thin steel strip traveling in the regulated moving line is grounded and electrodes are installed on both sides above and below this moving line in a plasma treating chamber. Plasma generating means are respectively provided on the outer side of the respective electrodes. Each of the plasma generating means is constituted of a filament, an anode electrode plate having plural holes and a cathode electrode plate having plural holes. A gaseous mixture composed N2 and H2 is introduced into this plasma generating means and is brought into collision against thermions, by which the gases are ionized and are converted to plasma. N ions are sticked to the thin steel strip by arc-discharging between the electrodes and the thin steel strip. Since the electrodes maintained at a positive potential are disposed to face the moving line at this time and, therefore, the thin steel strip is maintained at the negative potential relative to the electrodes even when the strip is grounded. The steel strip is thus subjected to the safe plasma treatment by the generated plasma.

JP H02 213460 A discloses a continuous heat-treating device for a steel sheet formed by a heating zone, a soaking zone, a cooling zone, a plasma treating zone and a cooling zone. The band steel is heated to a high temp. in the heating zone and the soaking zone, and a gas jet is blown against the heated sheet in the cooling zone to quench the sheet to 300-700 degrees C. The band steel is then treated with plasma in the plasma treating zone and then cooled in the cooling zone. At this time, a differential-pressure sealing device is provided in the inlet and outlet sides of the sheet in the plasma treating zone, and a plasma treating device to be evacuated from the atmospheric pressure to about 10⁻²-10Torr in several stages is provided.

US 6 361 628 B1 discloses a method for making a composite metal product by adding at least one substance to said product, which consists in using a metal product in the form of a continuous strip moved in a vacuum chamber, applying the substance on said strip and diffusing said substance at least partially into the strip when it is passing in the vacuum chamber maintaining it at a temperature lower than its melting point, but sufficiently high for enabling said diffusion.

US 2005/112377 A1 discloses a grain-oriented magnetic steel sheet comprising an electrically insulating coating, made of an amorphous carbon-hydrogen network, which is applied after final annealing in order to ensure electrical insulation of the individual layers of sheet, said grain-oriented magnetic steel sheet being used e.g. in transformers.

Further, a method for producing the grain-oriented magnetic steel sheet comprising an electrically insulating coating made of an amorphous carbon-hydrogen network is disclosed, which method consists of coating of the strip-shaped sheet substrate taking place in a continuous strip method.

### CITATION LIST

### Patent Literature

PTL 1 US1965559A
PTL 2 JPS4015644B
PTL 3 JPS5113469B
PTL 4 JP4321120B
PTL 5 JP2771634B
PTL 6 JPH03122227A
PTL 7 JP3940205B

### SUMMARY

However, with the technique disclosed in PTL 4, there were cases where the non-uniformity in the temperature and atmosphere during coil heating caused variation in the increase amount of sulfur in the coil and differences in secondary recrystallization behavior, which lead to variation of magnetic properties.

Further, the techniques disclosed in PTLs 5 to 7 are methods of performing nitriding by spraying nitriding gas on the steel sheet. Therefore, non-uniformity of the furnace temperature in terms of duration and position, and difference in decomposition amount of nitriding gas in pipes caused by heat could cause a difference in nitrogen increase depending on the area of the strip, and as a result, secondary recrystallization could become non-uniform and lead to deterioration of magnetic properties.

It could therefore be helpful to provide an apparatus for nitriding a grain-oriented electrical steel sheet which is very useful in obtaining excellent magnetic properties with no variation without containing inhibitor components in the slab when producing a grain-oriented electrical steel sheet, by performing appropriate nitriding before secondary recrystallization and uniformly dispersing inhibitor forming elements over the full length and full width of the strip, together with a nitriding method using the nitriding apparatus.

In order to solve the above problems, we have made intensive studies.

As a result, we discovered that, when performing continuous nitriding of a strip (steel sheet), by performing nitriding by utilizing glow discharge, the amount of nitridation can be controlled with high accuracy, the variation of said amount can be eliminated, the time required for treatment can be reduced, and therefore excellent magnetic properties can be obtained stably for the whole strip.

Further, we discovered that the above described plasma nitriding by glow discharge is the optimal structure as an apparatus required for nitriding the strip, and completed the disclosure.

The nitriding zone is provided with glow discharge electrodes, and the strip is subjected to plasma nitriding by glow discharge with the glow discharge electrodes functioning as positive electrodes and the strip functioning as a negative electrode. An apparatus for nitriding a grain-oriented electrical steel sheet according to the present invention is defined by the combination of features of claim 1. Dependent claims relate to preferred embodiments. A method according to the present invention is defined by the combination of features of claim 7.

With this disclosure, it is possible to suppress variation of nitriding and to stably guarantee a uniform amount of nitridation for the whole strip, and therefore it is possible to stably obtain excellent magnetic properties over the full length and full width of the strip.

Further, with this method, nitrogen gas can be used as a nitrogen source, and therefore nitrogen sources which may cause environmental problems such as ammonia required for performing gas nitriding, cyan salt required for performing salt bath nitriding or the like do not have to be used. For these reasons, our method has a significant industrial usefulness.

### BRIEF DESCRIPTION OF THE DRAWINGS

In the accompanying drawings:
FIG. 1 schematically shows a preferable example of the nitriding apparatus of the disclosure.
FIG. 2 shows a preferable example of a plasma nitriding device according to the disclosure.
FIG. 3 shows another example of a plasma nitriding device according to the disclosure.
FIG. 4 schematically shows another example of the nitriding apparatus of the disclosure.

### DETAILED DESCRIPTION

Our methods and components will be described in detail below.

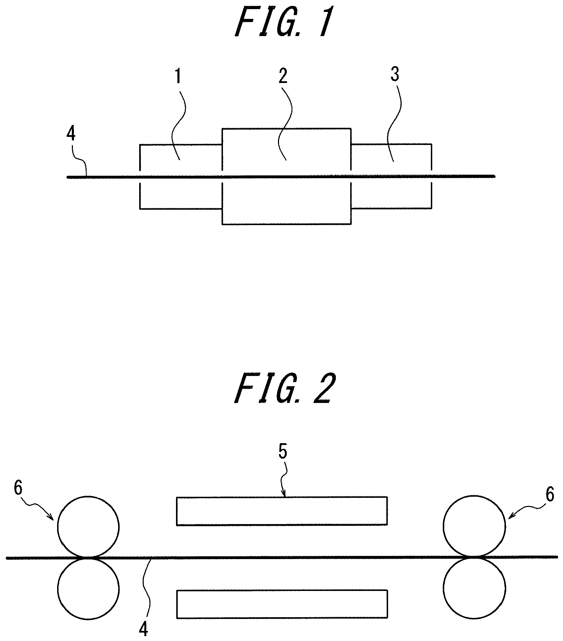

FIG. 1 schematically shows a preferable example of the nitriding apparatus of the disclosure. In the figure, a heating zone is labeled 1, a nitriding zone is labeled 2, and a cooling zone is labeled 3. Further, a strip (steel sheet) continuously passing inside the nitriding apparatus with a structure comprising the aforementioned components is labeled 4. The heating zone may be provided when required and is not always necessary.

In the disclosure, a strip 4 is subjected to plasma nitriding by glow discharge in the above nitriding zone 2.

FIG. 2 shows a preferable example of a plasma nitriding device according to the disclosure. In the figure, glow discharge electrodes are labeled 5, pinch rolls which also serve as electrode rolls are labeled 6, and in this example, glow discharge electrodes 5 are disposed above and below the strip 4. The inside of the nitriding zone 2 is filled with nitrogen gas and hydrogen gas as nitrogen sources.

With the glow discharge electrodes 5 functioning as positive electrodes and the strip 4 functioning as a negative electrode, voltage is applied between the electrodes via pinch rolls (electrode rolls) to generate glow discharge on both sides of the strip 4, to subject both sides of the strip 4 to nitriding at the same time in plasma atmosphere.

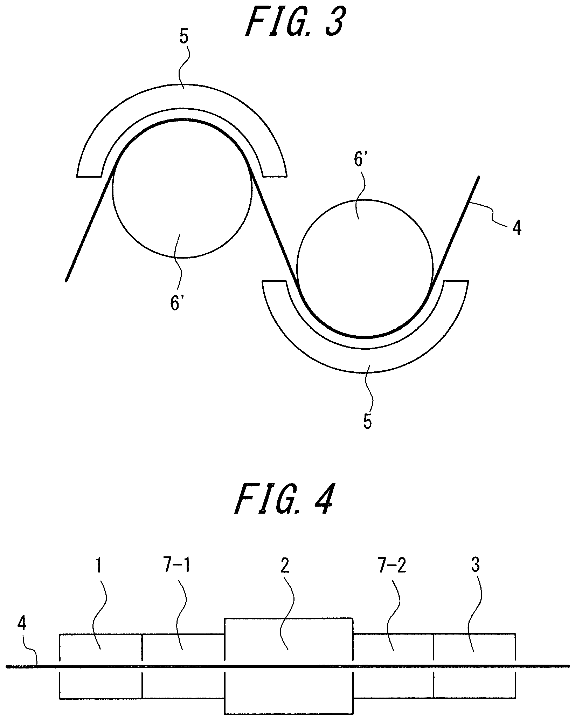

Further, FIG. 3 shows another example of a plasma nitriding device according to the disclosure. In this example, glow discharge is generated with a strip 4 arranged to be along electrode rolls 6' disposed opposite to positive electrodes (glow discharge electrodes) 5. In this example, nitriding is performed on only one side of the strip 4. Therefore, in order to perform nitriding on both sides of the strip 4, another nitriding device will be required.

When performing the above nitriding, the strip is preferably heated to a temperature of 400 °C or higher.

Further, the inside of the nitriding zone is preferably kept under a reduced pressure.

Further, although the heating zone and the cooling zone have a lower degree of pressure reduction compared to the nitriding zone, it is preferable for them to be kept in a state with reduced pressure compared to atmospheric pressure, and by doing so, heat exchange due to convection tends to proceed, and heating and cooling efficiency can be improved.

The inside of the nitriding zone is preferably depressurized to around 0.5 torr to 10 torr which is a preferable glow discharge condition, and the heating zone and the cooling zone are preferably depressurized, with a lower degree of pressure reduction, to around 30 torr to 500 torr.

Next, FIG. 4 shows an upstream atmosphere adjusting zone 7-1 and a downstream atmosphere adjusting zone 7-2 with a nitriding zone 2 in between.

In this case, each of the upstream atmosphere adjusting zone 7-1 and the downstream atmosphere adjusting zone 7-2 is preferably divided into multiple air chambers where the degrees of pressure reduction are individually adjustable. In a preferable construction, the degrees of pressure reduction of the air chambers in the upstream atmosphere adjusting zone 7-1 are gradually increased toward the nitriding zone 2, while the degree of pressure reduction of the air chambers in the downstream atmosphere adjusting zone 7-2 are gradually decreased from the nitriding zone 2 toward the cooling zone 3.

As the seal between each zone and each air chamber, conventionally known airtight seals may be used, such as rolls, seal pads and the like.

The inside of the nitriding zone is divided into multiple zones in the width direction of the strip where nitriding can be performed individually inside each divided zone. By adopting such structure, it is possible to effectively eliminate non-uniformity in nitridation in the width direction of the strip, such as excessive nitriding of the edges due to edge effects.

The heating zone can be omitted if it is disposed in a continuous line for performing other necessary treatment and the strip is already heated, or if the heating by plasma irradiation at the time of plasma nitriding is sufficient.

Further, in a case where another treatment is performed after plasma nitriding with the strip at a heated state, the cooling zone may be disposed after the zone for such treatment.

Further, the nitriding apparatus disclosed herein may be an independent apparatus that continuously performs only nitriding, or be attached to a processing line for performing another treatment, and in the case of a continuous line, it may be attached to the optimal place considering conditions including efficiency.

In the disclosure, the strip which is the material to be treated is not particularly limited and, as long as it is a grain-oriented electrical steel strip, any conventionally known strip is applicable.

### REFERENCE SIGNS LIST

1 Heating Zone
2 Nitriding Zone
3 Cooling Zone
4 Strip (Steel Sheet)
5 Glow Discharge Electrode
6 Pinch Roll (also serving as Electrode Roll)
6' Electrode Roll
7-1 Upstream Atmosphere Adjusting Zone
7-2 Downstream Atmosphere Adjusting Zone

## Claims

1. An apparatus for nitriding a grain-oriented electrical steel sheet for continuously nitriding a strip continuously being fed after cold rolling and before secondary recrystallization annealing in a production line of a grain-oriented electrical steel sheet, comprising:
a nitriding zone (2) for nitriding the strip; and
a cooling zone (3) for cooling the strip;
wherein the nitriding zone (2) is provided with glow discharge electrodes (5), the apparatus is configured to subject the strip to plasma nitriding by glow discharge with the glow discharge electrodes (5) functioning as positive electrodes and the strip functioning as a negative electrode, and
**characterized in that** the inside of the nitriding zone (2) is divided into multiple zones in the width direction of the strip to allow individual controls of nitriding inside each divided zone.

2. The apparatus for nitriding a grain-oriented electrical steel sheet according to claim 1, wherein the apparatus is configured to keep the nitriding zone (2) under reduced pressure.

3. The apparatus for nitriding a grain-oriented electrical steel sheet according to claim 2, further comprising:
a heating zone (1) provided upstream of the nitriding zone (2) for heating the strip, wherein the apparatus is configured to keep at least one of the heating zone (1) and the cooling zone (3) at a state with a lower degree of pressure reduction compared to the nitriding zone (2) and reduced pressure compared to atmospheric pressure.

4. The apparatus for nitriding a grain-oriented electrical steel sheet according to claim 3, further comprising an upstream atmosphere adjusting zone (7-1) provided between the heating zone (1) and the nitriding zone (2), and a downstream atmosphere adjusting zone (7-2) provided between the nitriding zone (2) and the cooling zone (3).

5. The apparatus for nitriding a grain-oriented electrical steel sheet according to claim 4, wherein the upstream atmosphere adjusting zone (7-1) and the downstream atmosphere adjusting zone (7-2) are each divided into multiple air chambers where the degrees of pressure reduction are individually adjustable.

6. The apparatus for nitriding a grain-oriented electrical steel sheet according to claim 5,
wherein the apparatus is configured to gradually increase the degrees of pressure reduction of the air chambers in the upstream atmosphere adjusting zone (7-1) toward the nitriding zone (2), while the apparatus is configured to gradually decrease the degree of pressure reduction of the air chambers in the downstream atmosphere adjusting zone (7-2) toward the cooling zone (3).

7. A method for nitriding a grain-oriented electrical steel sheet comprising plasma nitriding the strip by glow discharge using the apparatus according to any of claims 1 to 6 after cold rolling and before secondary recrystallization annealing during producing a grain-oriented electrical steel sheet.

## Patentansprüche

1. Vorrichtung zur Nitrierung eines kornorientierten Elektrostahlblechs zur kontinuierlichen Nitrierung eines Blechbands, das kontinuierlich, nach dem Kaltwalzen und vor dem sekundären Rekristallisationsglühen, in einer Produktionslinie für kornorientiertes Elektrostahlblech zugeführt wird, umfassend:
einer Nitrierzone (2) zur Nitrierung des Blechbandes; und
einer Abkühlzone (3) zur Abkühlung des Blechbands;
wobei die Nitrierzone (2) mit Glimmelektroden (5) ausgestattet ist, wobei die Vorrichtung dazu ausgebildet ist, das Band einer Plasmanitrierung durch Glimmentladung zu unterwerfen, wobei die Glimmelektroden (5) als positive Elektroden und das Blechband als negative Elektrode wirken, und **dadurch gekennzeichnet, dass** das Innere der Nitrierzone (2) in mehrere Zonen in Breitenrichtung des Bands unterteilt ist, um individuelle Steuerung der Nitrierung innerhalb jeder geteilten Zone zu ermöglichen.

2. Vorrichtung zur Nitrierung eines kornorientierten Elektrostahlblechs nach Anspruch 1, wobei die Vorrichtung dazu ausgestaltet ist, die Nitrierzone (2) unter reduziertem Druck zu halten.

3. Vorrichtung zur Nitrierung eines kornorientierten Elektrostahlblechs nach Anspruch 2, ferner Umfassend:
eine Erwärmungszone (1) die Stromauf der Nitrierzone (2) zur Erwärmung des Blechbands vorgesehen ist, wobei die Vorrichtung dazu ausgestaltet ist, die Erwärmungszone (1) oder die Abkühlzone (3) in einem Zustand mit weniger reduziertem Druck gegenüber der Nitrierzone (2) und geringerem Druck gegenüber dem Umgebungsdruck einzustellen.

4. Vorrichtung zur Nitrierung eines kornorientierten Elektrostahlblechs nach Anspruch 3, weiter umfassend eine vorgelagerte Atmosphärenanpassungszone (7-1),die zwischen der Erwärmungszone (1) und der Nitrierzone (2) vorgesehen ist, sowie eine nachgelagerte Atmosphärenanpassungszone (7-2), die zwischen der Nitrierzone (2) und der Abkühlzone (3) vorgesehen ist.

5. Vorrichtung zur Nitrierung eines kornorientierten Elektrostahlblechs nach Anspruch 4, wobei die vorgelagerte Atmosphärenanpassungszone (7-1) und die nachgelagerte Atmosphärenanpassungszone (7-2) jeweils in mehrere Luftkammern unterteilt sind, wo der Grad der Druckreduzierung individuell einstellbar ist.

6. Vorrichtung zur Nitrierung eines kornorientierten Elektrostahlblechs nach Anspruch 5, wobei die Vorrichtung ausgebildet ist den Grad der Reduktion des Drucks der Luftkammern fortschreitend in der vorgelagerten Atmosphärenanpassungszone (7-1) zur Nitrierzone (2) hin zu erhöhen, während die Vorrichtung ausgebildet ist, den Grad der Reduktion des Drucks fortschreitend in der nachgelagerten Atmosphärenanpassungszone (7-2) zur Abkühlzone (3) hin zu verringern.

7. Eine Methode zur Nitrierung eines kornorientierten Elektrostahlblechs umfassend eine Plasma-Nitrierung des Bands durch Glimmentladung unter Verwendung der Vorrichtung nach einem der Ansprüche 1 - 6 nach einem Kaltwalzen und vor einem sekundären Rekristallisationshärten während des Herstellens eines kornorientierten Elektrostahlblechs.

## Revendications

1. Appareil de nitruration d'une tôle d'acier électrique à grains orientés pour une nitruration de manière continue d'une bande qui est alimentée de manière continue après laminage à froid et avant un recuit de recristallisation secondaire dans une ligne de production d'une tôle d'acier électrique à grains orientés, comprenant :
une zone de nitruration (2) pour la nitruration de la bande ; et
une zone de refroidissement (3) pour refroidir la bande ;
dans lequel la zone de nitruration (2) est pourvue d'électrodes à décharge luminescente (5), l'appareil est configuré pour soumettre la bande à une nitruration à plasma par décharge luminescente, les électrodes à décharge luminescente (5) fonctionnant comme des électrodes positives et la bande fonctionnant comme une électrode négative, et
**caractérisé en ce que** l'intérieur de la zone de nitruration (2) est divisé en de multiples zones dans la direction de largeur de la bande pour permettre des contrôles individuels de nitruration à l'intérieur de chaque zone divisée.

2. Appareil de nitruration d'une tôle d'acier électrique à grains orientés selon la revendication 1, dans lequel l'appareil est configuré pour maintenir la zone de nitruration (2) sous une pression réduite.

3. Appareil de nitruration d'une tôle d'acier électrique à grains orientés selon la revendication 2, comprenant en outre :
une zone de chauffage (1) pourvue en amont de la zone de nitruration (2) pour chauffer la bande, dans lequel l'appareil est configuré pour maintenir au moins une de la zone de chauffage (1) et de la zone de refroidissement (3) dans un état ayant un degré de réduction de pression plus faible par rapport à la zone de nitruration (2) et une pression réduite par rapport à la pression atmosphérique.

4. Appareil de nitruration d'une tôle d'acier électrique à grains orientés selon la revendication 3, comprenant en outre une zone d'ajustement d'atmosphère amont (7-1) pourvue entre la zone de chauffage (1) et la zone de nitruration (2), et une zone d'ajustement d'atmosphère aval (7-2) pourvue entre la zone de nitruration (2) et la zone de refroidissement (3).

5. Appareil de nitruration d'une tôle d'acier électrique à grains orientés selon la revendication 4, dans lequel la zone d'ajustement d'atmosphère amont (7-1) et la zone d'ajustement d'atmosphère aval (7-2) sont chacune divisées en de multiples chambres à air où les degrés de réduction de pression sont ajustables individuellement.

6. Appareil de nitruration d'une tôle d'acier électrique à grains orientés selon la revendication 5,
dans lequel l'appareil est configuré pour augmenter graduellement les degrés de réduction de pression dans les chambres à air dans la zone d'ajustement d'atmosphère amont (7-1) en direction de la zone de nitruration (2), pendant que l'appareil est configuré pour diminuer graduellement le degré de réduction de pression des chambres à air dans la zone d'ajustement d'atmosphère aval (7-2) en direction de la zone de refroidissement (3).

7. Procédé de nitruration d'une tôle d'acier électrique à grains orientés comprenant une nitruration à plasma de la bande par décharge luminescente à l'aide de l'appareil selon l'une quelconque des revendications 1 à 6 après laminage à froid et avant un recuit de recristallisation secondaire pendant la production d'une tôle d'acier électrique à grains orientés.
